Europäisches Patentamt

European Patent Office

Office européen des brevets

(19)

(11) Veröffentlichungsnummer : **0 156 442**
**B1**

(12) **EUROPÄISCHE PATENTSCHRIFT**

(45) Veröffentlichungstag der Patentschrift :
07.06.89

(21) Anmeldenummer : 85200457.1

(22) Anmeldetag : 25.03.85

(51) Int. Cl.⁴ : **G 01 N 24/06, G 01 N 24/08**

(54) Kernspintomograph.

(30) Priorität : 27.03.84 DE 3411222

(43) Veröffentlichungstag der Anmeldung :
02.10.85 Patentblatt 85/40

(45) Bekanntmachung des Hinweises auf die Patenterteilung : 07.06.89 Patentblatt 89/23

(84) Benannte Vertragsstaaten :
DE FR GB NL

(56) Entgegenhaltungen :
GB-A- 2 070 254
THE REVIEW OF SCIENTIFIC INSTRUMENTS, Band
32, Nr. 3, März 1961, Seiten 241-250, American Institute of Physics, New York, US; W.A. ANDERSON:
"Electrical current shims for correcting magnetic
fields"

(73) Patentinhaber : Philips Patentverwaltung GmbH
Wendenstrasse 35 Postfach 10 51 49
D-2000 Hamburg 1 (DE)
DE
N.V. Philips' Gloeilampenfabrieken
Groenewoudseweg 1
NL-5621 BA Eindhoven (NL)
FR GB NL

(72) Erfinder : Kunz, Dietmar, Dr.
Boxholmstrasse 9
D-2085 Quickborn (DE)

(74) Vertreter : Hartmann, Heinrich, Dipl.-Ing. et al
Philips Patentverwaltung GmbH Wendenstrasse 35
Postfach 10 51 49
D-2000 Hamburg 1 (DE)

EP 0 156 442 B1

**Beschreibung**

Die Erfindung betrifft einen Kernspintomographen mit einer Anordnung zur Erzeugung eines homogenen statischen Magnetfeldes, mit drei Spulenanordnungen, die von zeitlich veränderlichen Strömen durchflossen werden und zur Erzeugung von in Richtung des statischen Magnetfeldes verlaufenden Zusatzmagnetfeldern dienen, die sich in drei zueinander senkrechten Richtungen linear ändern, und mit einer Hochfrequenzspule zur Erzeugung eines hochfrequenten, zur Richtung des Hauptfeldes senkrechten Magnetfeldes, wobei die Magnetflußdichte des homogenen statischen Magnetfeldes durch Überlagerung eines weiteren Magnetfeldes in definierter Weise räumlich und zeitlich geändert wird.

Ein solcher Kerspintomograph ist bekannt — z. B. aus der DE-OS 28 49 355 — und zur Erläuterung in Fig. 1 teilweise aufgebrochen dargestellt. Der Kernspintomograph umfaßt eine Anordnung zur Erzeugung eines starken homogenen statischen Magnetfeldes, das in z-Richtung eines xyz-Koordinatensystems verläuft. Diese Anordnung besteht aus vier zueinander konzentrischen ringförmigen Spulen 1, deren Mittelachse in z-Richtung verläuft. Im Innern dieser Spulen ist das Magnetfeld in einem relativ großen Bereich — dem Untersuchungsbereich — homogen und besitzt eine Flußdichte zwischen 0,1 T und 2 T, wobei die höheren Flußdichten im allgemeinen mit Hilfe einer supraleitenden Spulenanordnung erzeugt werden müssen. Zur Untersuchung wird in diesen Untersuchungsbereich ein auf einem Patientenlagerungstisch 2 mit einer in z-Richtung verfahrbaren Tischplatte 3 befindlicher Patient 4 gebracht.

Außerdem besitzt der Kernspintomograph drei Spulenanordnungen zur Erzeugung von in z-Richtung verlaufenden Magnetfeldern, die sich in der x-, der y- und der z-Richtung räumlich linear ändern. Diese Spulenanordnungen werden in der Literatur in der Regel als « Gradientenspulen » bezeichnet. Die Spulenanordnung zur Erzeugung eines in z-Richtung verlaufenden und in dieser Richtung linear abnehmenden Magnetfeldes besteht aus wenigstens zwei gleichartigen in z-Richtung gegeneinander versetzten und zu den Spulen 1 symmetrisch angeordneten Spulen Gz, zwischen denen ein in z-Richtung verlaufendes und in dieser Richtung sich linear mit dem Ort änderndes Magnetfeld erzeugt wird, wenn diese Spulen gegensinnig von einem Strom durchflossen werden.

Die Spulenanordnung zur Erzeugung eines ebenfalls in z-Richtung verlaufenden Magnetfeldes, das sich jedoch in x-Richtung räumlich linear ändert, besteht aus vier gleichen Spulen Gx. Diese annähernd rechteckigen Spulen sind auf dem Umfang eines Kreiszylinders angeordnet, dessen Mittellinie parallel zur y-Achse ist und das Zentrum der Ringe 1 und damit des Untersuchungsbereiches durchstößt. Die vier Spulen Gx werden von Strömen gleicher Größe durchflossen, die so gerichtet sind, daß in benachbarten Spulen die der jeweils anderen Spule zugewandten, in y-Richtung verlaufenden Teile in derselben Richtung durchströmt werden.

Die Spulenanordnung Gy zur Erzeugung eines in z-Richtung verlaufenden Magnetfeldes, das sich in y-Richtung linear mit dem Ort ändert, hat den gleichen Aufbau wie die Spulenanordnung Gx, ist dieser gegenüber jedoch um 90° gedreht. D. h. auch diese Spulenanordnung besteht aus vier auf dem Umfang eines Kreiszylinders angeordneten Rechteckspulen Gy, wobei die Mittelachse dieses Kreiszylinders jedoch parallel zur x-Achse durch das Zentrum des Untersuchungsbereiches verläuft. - Das von den Spulenanordnungen Gx und Gy erzeugte Magnetfeld hat in der in z-Richtung verlaufenden Symmetrieachse die Flußdichte Null.

Schließlich ist noch eine Hochfrequenzspule 5 vorgesehen, die im Untersuchungsbereich ein homogenes hochfrequentes Magnetfeld erzeugt, dessen Frequenz der Lamorfrequenz entspricht, mit der die im Untersuchungsbereich erzeugten Kernspins um die z-Achse präzedieren.

Bei einem üblichen mit einem derartigen Kernspintomographen durchgeführten Verfahren werden in einer Schicht des zu untersuchenden Objektes die Kernspins angeregt. Zu diesem Zweck werden während der Anregung der Kernspins durch die Hochfrequenzspule 5 die Gradientenspulen Gz durch einen Strom erregt, so daß sich das von den Spulen 1 und Gz erzeugte Magnetfeld von der einen Spule Gz zur anderen linear ändert. Dadurch werden die Kernspins in derjenigen Schicht angeregt, deren Lamorfrequenz — die Lamorfrequenz ist bekanntlich der magnetischen Feldstärke proportional — der Frequenz des Hochfrequenzfeldes entspricht. Anschließend werden die Spulen Gx und Gy — in der Regel nacheinander oder zeitlich phasenverschoben — erregt, so daß sich das Magnetfeld innerhalb der Schicht in x- bzw. y-Richtung ändert. Dadurch werden die Phasen und die Amplitude des nach der Anregung in der Spule 5 induzierten Signals so beeinflußt, daß die Kernspinverteilung in der angeregten Schicht rekonstruiert werden kann.

Die Qualität der Rekonstruktion wird dadurch beeinträchtigt, daß die Gradientenfelder nicht exakt den vorbestimmten räumlichen Verlauf haben, sich z. B. nicht exakt linear als Funktion des Ortes ändern. Erschwerend kommt hinzu, daß diese Abweichung von dem vorgegebenen Verlauf zeitabhängig ist. Ursache dafür sind die Wirbelströme, die beim Einschalten der Ströme durch die Gradientenspulen auftreten und die Magnetfelder hervorrufen, die in ihrer räumlichen Abhängigkeit von dem Feld der Spule abweichen können.

Es ist bekannt, zur Verringerung dieser Effekte dem Strom durch die Gradientenspule einen zeitlichen Verlauf zu geben, der von dem gewünschten zeitlichen Verlauf des Magnetfeldes abweicht; soll beispielsweise das Magnetfeld einer Gradientenspule sprungartig auf einen bestimmten Wert geschaltet werden, wird dieser Gradientenspule ein Strom zugeführt, der bei der Einschaltflanke über seinen stationären Wert hinausgeht. Diese Maßnahme hat indes nur begrenzten Erfolg.

Aufgabe der vorliegenden Erfindung ist es, den Einfluß der bei der Erregung der Gradientenspulen auftretenden Wirbelströme und anderer Ungenauigkeiten auf den räumlichen Verlauf der Magnetfelder zu verringern.

Diese Aufgabe wird erfindungsgemäß dadurch gelöst, daß wenigstens eine weitere Spulenanordnung vorhanden ist zur Erzeugung eines ebenfalls in Richtung des Hauptfeldes verlaufenden Magnetfeldes, das sich räumlich nichtlinear ändert, und daß der zeitliche Verlauf der Ströme durch die Spulenanordnungen so bemessen ist, daß sich durch Überlagerung der Magnetfelder sämtlicher Spulenanordnungen die definierte zeitlich-räumliche Änderung der Magnetflußdichte ergibt.

Mit einer einzigen weiteren Spulenanordnung lassen sich die Abweichungen vom gewünschten zeitlich räumlichen Verlauf in der Regel nur unvollständig beseitigen. Diese hängen einerseits vom konkreten Aufbau des Kernspin-Resonanzgerätes ab und andererseits auch von Ausmaß und Ursache der Abweichungen vom gewünschten Verlauf ab. Die durch das Auftreten von Wirbelströmen hervorgerufenen Abweichungen beispielsweise werden ihrerseits durch den zeitlichen Verlauf der Anregung der Gradientenspulen bestimmt ; die Wirbelströme sind um so ausgeprägter, je höhere Frequenzkomponenten die Anregungsfunktion der Gradientenspulen enthält.

Eine Weiterbildung der Erfindung sieht vor, daß bis zu fünf zusätzliche Spulenanordnungen vorgesehen sind, die Magnetfelder erzeugen, deren räumlicher Verlauf dem räumlichen Verlauf der Kugelfunktionen zweiter Ordnung entspricht.

Dieser Weiterbildung liegt folgende Überlegung zugrunde. Jedes beliebige magnetische Feld — u. a. auch das von den Gradientenspulen erzeugte Magnetfeld sowie das von den damit verknüpften Wirbelströmen hervorgerufene Magnetfeld — läßt sich als gewichtete Summe von Kugelfunktionen der nullten, ersten, zweiten, dritten ... Ordnung darstellen, wobei die Zahl der Ordnungen an sich unendlich ist. Im allgemeinen sind die Magnetfeldkomponenten, die sich entsprechend Kugelfunktionen höherer Ordnung ändern, aber vernachlässigbar. Da sich das Magnetfeld der Gradientenspulen zeitlich ändert, ändern sich auch die Gewichtungsfaktoren, mit denen die einzelnen Kugelfunktionen in die erwähnte gewichtete Summe eingehen zeitlich. Die fünf zusätzlichen Spulenanordnungen, die je einer der fünf Kugelfunktionen zweiter Ordnung entsprechen, die Gradientenspulen (Gx, Gy, Gz), die je einer Kugelfunktion erster Ordnung entsprechen, und die Spulenanordnung (1) für das Hauptmagnetfeld schaffen nun die Möglichkeit, ein Magnetfeld mit beliebigem räumlichen Verlauf zu erzeugen — wenn man von Komponenten, die der dritten oder höheren Harmonischen der Kugelfunktionen entsprechen, absieht —, wenn die Beiträge der einzelnen Spulen in geeigneter Weise gewichtet werden. Ein gewünschter zeitlicher Verlauf läßt sich daher dadurch erzeugen, daß die Gewichtungsfaktoren, mit denen die einzelnen Spulen zum resultierenden Magnetfeld beitragen, d. h. die Ströme durch diese Spulen in geeigneter Weise variiert werden.

Auf einer ähnlichen Überlegung basiert eine weitere Ausgestaltung, die vorsieht, daß bis zu sieben weitere Spulenanordnungen vorgesehen sind, die ein Magnetfeld erzeugen, dessen räumlicher Verlauf dem räumlichen Verauf der Kugelfunktionen dritter Ordnung entspricht. Damit lassen sich die Abweichungen vom gewünschten zeitlich-räumlichen Verlauf noch besser kompensieren, da auch Abweichungen dritter Ordnung kompensiert werden können.

Es sei bemerkt, daß mit der Erfindung der gewünschte räumlich-zeitliche Verlauf des Magnetfeldes nicht exakt erzielt werden kann ; durch die zusätzliche(n) Spulenanordnung(en) wird bzw. werden die Abweichungen von diesem Verlauf jedoch verringert.

Die Erfindung wird nachstehend anhand der Zeichnung näher erläutert. Es zeigen

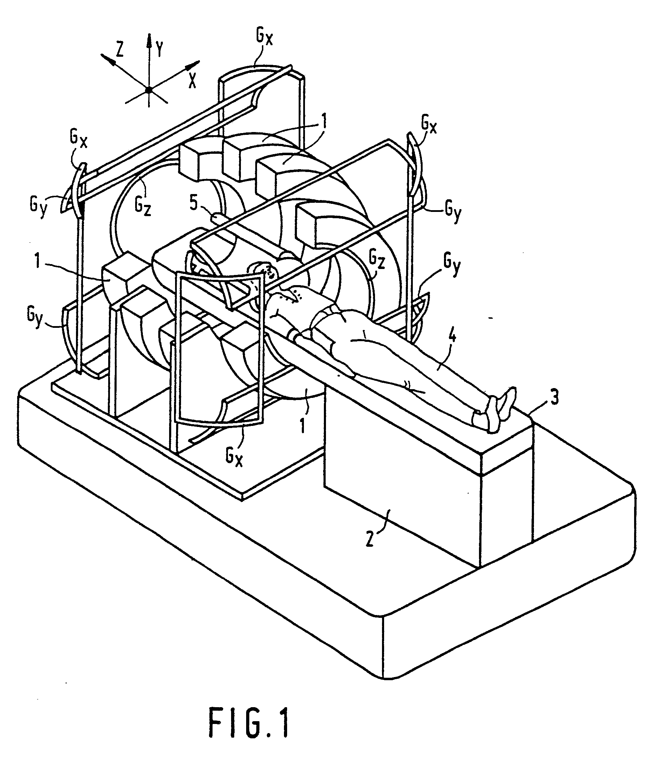

Fig. 1 eine Ansicht eines bekannten Kernspintomographen,

Fig. 2 ein schematisches Blockschaltbild eines erfindungsgemäßen Kernspintomographen.

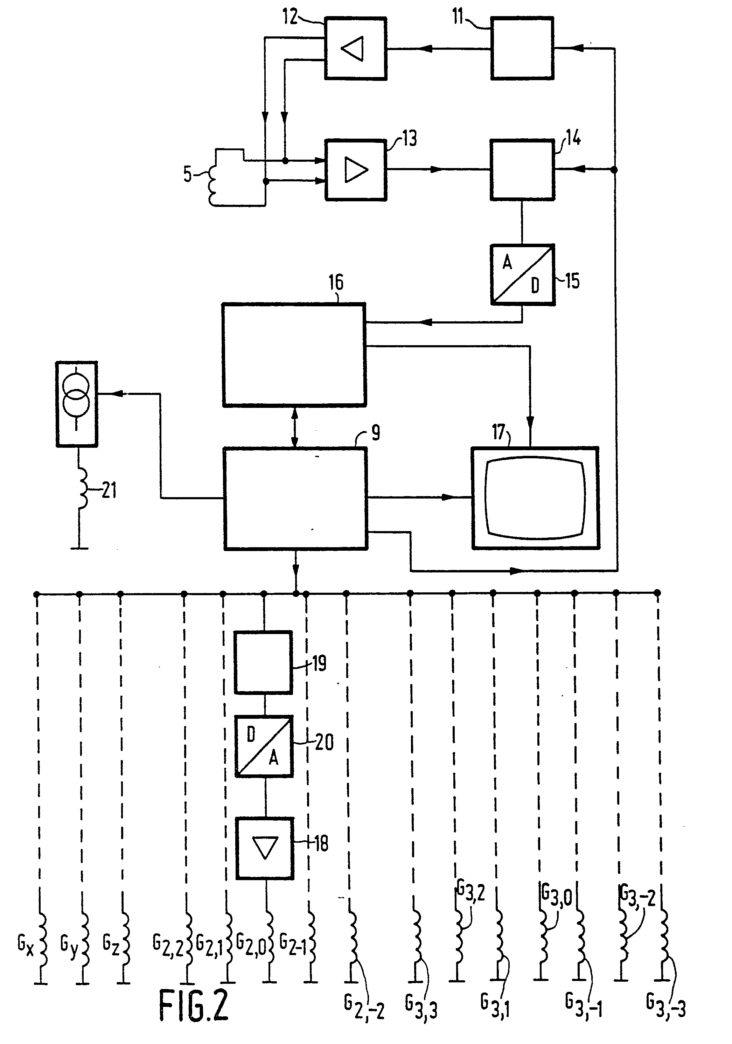

Die in Fig.2 dargestellte Anordnung enthält eine Steueranordnung 9, die u. a. einen Modulator 11 steuert. Der Modulator 11 erzeugt eine Trägerschwingung, die über einen Leistungsverstärker 12 der Hochfrequenzspule 5 zugeführt wird, wobei die Frequenz der modulierten Schwingung sowie die Größe des durch die Spulen 1 erzeugten Magnetfeldes so aufeinander abgestimmt sind, daß in einer Schicht des untersuchten Körpers 4 Kernspinresonanz angeregt wird. Die im Anschluß an diese Anregung in der Spule 5 induzierten Signale werden über einen Verstärker 13 einem phasenempfindlichen Demodulator 14 zugeführt, dessen Ausgangssignal von einem Digital-Analog-Wandler 15 in ein digitales Datenwort umgesetzt und einer Rekonstruktionseinheit 16 zugeführt wird. Diese ermittelt aus den zugeführten Daten nach einem vorgegebenen Algorithmus die räumliche Verteilung der Kernspins in der angeregten Schicht, und diese Verteilung wird beispielsweise mittels eines Monitors 17 dargestellt.

Die Steuereinrichtung 9 steuert darüber hinaus den Strom durch die Gradientenspulen Gx, Gy bzw. Gz, die ein in z-Richtung verlaufendes Magnetfeld erzeugen, das sich linear in x-, y- bzw. z-Richtung ändert. Insoweit als bisher beschrieben ist auch diese Anordnung bekannt. Erfindungsgemäß sind jedoch zwölf zusätzliche Spulenanordnungen vorgesehen, die jeweils aus mehreren einzelnen Spulen bestehen, die bezüglich des Zentrums des Untersuchungsbereiches symmetrisch angeordnet sind, so daß das von ihnen erzeugte, in z-Richtung verlaufende Magnetfeld sich symmetrisch in bezug auf dieses Zentrum ändert — und zwar entweder quadratisch oder kubisch mit dem Abstand von dem Zentrum. Fünf der zwölf Spulenanordnungen — nämlich die Spulenanordnungen $G_{2,2}$ ... $G_{2,-2}$ erzeugen dabei Magnetfelder, deren Flußdichte jeweils proportional zu einer der fünf Kugelfunktionen zweiter Ordnung verläuft, während die magnetische Flußdichte der übrigen sieben Spulen — $G_{3,3} \ldots G_{3,-3}$ — proportional zu je einer der sieben Kugelfunktionen dritter Ordnung verläuft. Der räumliche Verlauf des von einer Spule $G_{l,m}$ erzeugten Magnetfeldes ist dabei einer Kugelfunktion $f_{l,m}$ wenigstens näherungsweise proportional, wobei l in dem Ausführungsbeispiel zwischen 2 und 3 liegt und m zwischen $+3$ und $-3$. Die Kugelfunktion $f_{l,m}$ ist dabei wie folgt definiert

$$f_{l,m} = \begin{cases} r^l P_{l,m}(\cos a) \cdot \cos mb & \text{für } m \geq 0 \\ r^l P_{l,-m}(\cos a) \cdot \sin(-mb) & \text{für } m < 0 \end{cases} \tag{1}$$

Dabei ist r der Abstand eines Punktes vom Koordinatenursprung, der mit dem Zentrum des Untersuchungsbereiches zusammenfällt, a der Winkel, den die Gerade zwischen dem Koordinatenursprung und dem Punkt mit der z-Achse einschließt, b der Winkel, den die Projektion dieser Geraden auf eine Ebene z = const mit der x-Achse einschließt, und $P_{l,m}(..)$ die m-te Ableitung des Legendre-Polynoms des Grades 1 nach seinem Argument (..), wobei $P_{l,m}(..)$ für m = 0 dem Legendre-Polynom des Grades 1 entspricht. Da nur 1 Ableitungen eines Legendre-Polynoms nach seinem Argument von Null verschieden sind und da sin mb für m = 0 zu Null wird, gibt es nur $2l + 1$ Kugelfunktionen der Ordnung 1, d. h. fünf ($2 \times 2 + 1$) Kugelfunktionen zweiter Ordnung und sieben ($2 \times 3 + 1$) Kugelfunktionen dritter Ordnung.

Wie Spulenanordnungen aufgebaut sind, deren Magnetfeld im wesentlichen proportional zu einer Kugelfunktion verläuft, ist in der US-PS 3 566 255 im einzelnen beschrieben, wobei die Spulen $G_{2,2} \ldots G_{2,-2}$ den dort in den Figuren 3 bis 7 gezeigten Spulen entsprechen, während der Aufbau der Spulen $G_{3,3} \ldots G_{3,-3}$ den Figuren 9 bis 15 zu entnehmen ist. Die Berechnung und der Entwurf derartiger Spulen ist auch in « The Review of Scientific Instruments » Vol. 32, Nr. 3, Seiten 241 bis 250 beschrieben.

Wie aus Fig. 2 ersichtlich, wird der Strom für die Spule $G_{2,0}$ von einem Leistungsverstärker 18 mit genügend hohem Ausgangswiderstand geliefert. Das Eingangssignal des Leistungsverstärkers stammt von einem Funktionsgenerator, der aus einem Speicher 19 mit nachgeschaltetem Digital-Analog-Wandler 20 besteht. In dem Speicher 19 ist eine Vielzahl von Datenworten gespeichert, deren Folge dem zeitlichen Verlauf des Stromes durch die Spule $G_{2,0}$ entspricht. Die Datenworte in dem Speicher 19 werden durch die Steuereinrichtung 9 gesteuert ausgelesen, von dem Digital-Analog-Wandler 20 in ein analoges Signal umgesetzt dem Eingang des Verstärkers 18 insbesondere über einen geeigneten Tiefpaß zugeführt, wobei der Verstärker 18 einen Strom erzeugt, dessen zeitlicher Verlauf der Folge der in dem Speicher 19 gespeicherten Datenworte entspricht. — Der Strom für alle anderen Spulenanordnungen mit Einschluß der Spulen Gx, Gy, Gz wird von identisch aufgebauten Einrichtungen 18 ... 20 geliefert, die in Fig. 2 jedoch nicht näher dargestellt sind. Der einzige Unterschied besteht darin, daß in dem den einzelnen Spulenanordnungen zugeordneten Speichern unterschiedliche Folgen von Datenworten gespeichert sind, weil die Ströme durch diese Spulen unterschiedliche zeitliche Verläufe aufweisen. Die zeitlichen Verläufe der Ströme durch die einzelnen Spulen, d. h. die Folge der Datenworte in den Speicher 19 ist so gewählt, daß die lineare Überlagerung der von den einzelnen Spulenanordnungen erzeugten Magnetfelder gerade den gewünschten zeitlich räumlichen Verlauf des Magnetfeldes ergibt.

Dieser zeitlich räumliche Verlauf kann eine erste Phase enthalten, in der sich das Magnetfeld während eines vorgegebenen Zeitraumes in z-Richtung räumlich linear ändert (dadurch wird die Position der Schicht festgelegt, deren Kernspinverteilung anschließend gemessen wird). In einer daran anschließenden Phase wird während eines definierten Zeitraums ein zeitlich und räumlich konstanter Gradient des Magnetfeldes beispielsweise in y-Richtung erzeugt, während in einer dritten Phase während eines bestimmten Zeitraumes in x-Richtung ein räumlich und zeitlich konstanter Gradient der Magnetflußdichte erzeugt wird. In jeder der drei Phasen ist nicht nur die jeweils zugehörige Gradienten-Spulenanordnung erregt (in der zweiten Phase beispielsweise die Spulenanordnung Gy), sondern in der Regel auch alle anderen Spulenanordnungen mit Einschluß der anderen Gradienten-Spulenanordnungen (Gx, Gz).

Im folgenden wird ein Verfahren zur Bestimmung der zeitlichen Verläufe der Ströme in den verschiedenen Spulen bzw. der Folge der Datenworte in den verschiedenen diesen Spulen zugeordneten Speichern angegeben. Dieses Verfahren umfaßt folgende Schritte :

1) Jeweils einer der Spulen wird ein sinusförmiger Strom zugeführt. Das daraus resultierende Magnetfeld in einem Punkt innerhalb der Spulenanordnung mit dem Abstand r von dem Koordinatenursprung, d. h. vom Zentrum des Untersuchungsbereiches, wird nach Betrag und Phase gemessen (bezogen auf die Phase des Wechselstromes in der Spule). Diese Messung wird für verschiedene Frequenzen wiederholt. Die Frequenzen sind dabei so gewählt, daß sie dem Spektralbereich entsprechen, der bei der Erregung der Gradienten-Spulenanordnungen resultiert. Die beschrieben Messungen werden für N Punkte auf der Oberfläche der Kugel mit dem Radius r wiederholt, wobei gilt :

$$N = (l_0 + 1)^2 \tag{2}$$

Dabei ist $l_0$ die höchste Ordnung der Kugelfunktionen, die mit den Spulenanordnungen vollständig und unabhängig voneinander erzeugt werden können; im Ausführungsbeispiel nach Fig. 2 ist $l_0$ also

4

gleich 3, so daß an insgesamt 16 verschiedenen Punkten auf der Kugeloberfläche gemessen werden muß. Die verschiedenen Messungen werden für sämtliche Spulenanordnungen wiederholt.

Die in einem Punkt für eine Spule und für eine Frequenz gemessene Magnetflußdichte B läßt sich als gewichtete Summe von Kugelfunktionen darstellen gemäß der folgenden Gleichung :

$$B = \sum_{l=0}^{l_0} \sum_{m=-1}^{+1} a_{lm} \cdot f_{l,m} \tag{3}$$

$f_{l,m}$ ist dabei die anhand von Gleichung (1) definierte Kugelfunktion für den betreffenden Punkt, d. h. also ein berechenbarer bzw. aus Tabellen entnehmbarer Zahlenwert, während $a_{lm}$ den zugehörigen Gewichtungsfaktor darstellt, der in der Regel einen Real- und einen Imaginärteil aufweist, da ja auch die Größe B in der Regel einen Real- und Imaginärteil aufweist. Da es von der nullten Ordnung bis zur dritten Ordnung ($l_0$) insgesamt 16 (N) Kugelfunktionen gibt, umfaßt die gewichtete Summe gemäß Gleichung (3) auch 16 Gewichtungsfaktoren $a_{lm}$. Da nun für die gleiche Spulenanordnung und für die gleiche Frequenz die Magnetflußdichte an 16 (N) verschiedenen Punkten auf der Kugeloberfläche gemessen wurde, ergeben sich für die 16 unbekannten $a_{lm}$ 16 lineare Gleichungen, aus denen nach bekannten Verfahren die 16 Gewichtungsfaktoren $a_{lm}$ errechnet werden können. Diese Berechnung wird für die verschiedenen Meßfrequenzen wiederholt, wobei sich für jede Frequenz Gewichtungsfaktoren $a_{lm}$ ergeben können, die von den zuvor gemessenen Gewichtungsfaktoren abweichen. Auf diese Weise erhält man einen Satz ggf. frequenzabhängiger Faktoren $a_{lm}$, die die Eigenschaften der Spulenanordnung bis zu den dritten Harmonischen bzw. bis zu Kugelfunktionen dritter Ordnung vollständig beschreiben. Dieser Satz von Gewichtungsfaktoren stelle einen N-dimensionalen Vektor dar, dessen einzelne Komponenten ($a_{lm}$) frequenzabhängig sind.

Die gleiche Rechnung wird auch für alle anderen Spulen durchgeführt, so daß für jede Spule ein N-dimensionaler Vektor erhalten wird, wobei die verschiedenen $a_{lm}$ in allen Vektoren in der gleichen Reihenfolge angeordnet sind. Auch für die das räumlich — in der Regel auch zeitlich — konstante Magnetfeld erzeugende Spulenanordnung wird ein solcher Vektor gebildet. Hierbei gibt es zwei Möglichkeiten :

a) Es wird für die Spule 1 ein Vektor definiert, bei dem alle Komponenten den Wert Null haben mit Ausnahme der Komponente $a_{00}$, die auf einen beliebigen frequenzunabhängigen Wert festgesetzt wird. In diesem Falle sind aber bei der Messung der Kernspinverteilung Korrekturen erforderlich.

b) Es wird eine zweite in Fig. 2 nicht näher dargestellte Spulenanordnung installiert, die ein in z-Richtung verlaufendes und ebenfalls räumlich konstantes Magnetfeld erzeugt. Allerdings ist dieses Magnetfeld wesentlich schwächer als das Hauptmagnetfeld, und der Strom durch diese Spulen ist zeitlich variabel und wird auf die gleiche Weise erzeugt wie der Strom durch alle anderen Spulen.

Auf diese Weise ergibt sich für alle 16 (N) Spulenanordnungen ein Vektor mit je 16 (N) Komponenten $a_{lm}$. Diese Vektoren werden als Spaltenvektoren zu einer Matrix zusammengefaßt, wobei die einzelnen Spaltenvektoren so angeordnet sind, daß die dominierende Komponente in der Hauptdiagonale der Matrix liegt. Die so erhaltene Matrix wird nachfolgend mit A(w) bezeichnet, wobei w die Frequenzabhängigkeit der Matrixelemente andeutet.

2) Die Matrix A(w) wird invertiert, so daß eine Matrix $A^{-1}(w)$ resultiert. Bekanntlich ergibt das Produkt einer Matrix mit ihrer invertierten Matrix eine Einheitsmatrix, d. h. eine Matrix, bei der alle Elemente der Hauptdiagonale den Wert 1 haben, während alle anderen Elemente 0 sind. Eine weitere Eigenschaft der invertieren Matrix ist, daß die Indizierungen von Spalten und Zeilen vertauscht werden. Wenn also in der Matrix A der Spule $G_{2,0}$ der siebte Spaltenvektor zugeordnet war, ist ihr in der invertierten Matrix $A^{-1}$ der siebte Zeilenvektor zugeordnet.

3) Der gewünschte zeitlich-räumliche Verlauf des Magnetfeldes Bg wird im Untersuchungsbereich für eine Vielzahl verschiedener Zeitpunkte bestimmt, und für jeden Zeitpunkt wird eine gewichtete Summe von Kugelfunktionen gemäß Gleichung

$$Bg = \sum_{l=0}^{l_0} \sum_{m=-1}^{+1} c_{lm} \cdot f_{l,m} \tag{4}$$

gebildet. Dabei ist $c_{lm}$ der Gewichtungsfaktor, mit dem die Kugelfunktion $f_{l,m}$ in die gewichtete Summe eingeht. Es resultiert somit wiederum ein N-dimensionaler Vektor mit den zietabhängigen Elementen $c_{lm}$. Wenn das Magnetfeld sich beispielsweise räumlich linear ändern soll, sind in diesem Vektor nur diejenigen Kompenenten von Null verschieden, für die l = 1 gilt.

4) Die einzelnen zeitabhängigen Komponenten $c_{lm}(t)$ werden mit Hilfe der Fourier-Transformation aus den Zeitbereich in den Frequenzbereich transformiert, so daß ein Vektor D(w) mit N frequenzabhängigen Komponenten $d_{lm}(w)$ resultiert.

5) Der resultierende Vektor D(w) wird mit der invertierten Matrix $A^{-1}(w)$ multipliziert. Das Ergebnis ist ein N-dimensionaler Vektor I(w).

6) Die N Komponenten des Vektors I(w) werden in den Zeitbereich transformiert. Die Komponente $i_j(t)$ (j = 1...N) des in den Zeitbereich transformierten Vektors stellt dabei den zeitlichen Verlauf des Stromes dar, der durch die Spulenanordnung fließen muß, welcher der j-te Spaltenvektor der Matrix A bzw. der j-te Zeilenvektor der Matrix $A^{-1}$ zugeordnet ist.

7) Die den einzelen Spulen zugeordneten Stromverläufe werden in eine entsprechende Folge von Datenworten umgesetzt, die in den Speicher 19 eingeschrieben werden, der der betreffenden Spulenanordnung zugordnet ist.

Nachdem auf diese Weise einmal der zeitliche Verlauf der Ströme durch die einzelnen Spulen bestimmt worden ist, können die in den Speichern 19 gespeicherten Datenworte immer wieder zur Erzeugung des in z-Richtung verlaufenden, sich nach einer vorgegebenen Funktion von Ort und Zeit ändernden Magnetfeldes herangezogen werden. Dies gilt auch für Kernspintomographen des gleichen Typs, wenn sichergestellt ist, daß die Fabrikation des Kernspintomographens und sein Aufstellungsort keinen Einfluß auf die damit erzeugten Magnetfelder haben.

Für den Fall, daß ein anderer räumlich zeitlicher Verlauf erwünscht ist, brauchen lediglich die vorstehend beschriebenen Schritte 3) bis 7) neu durchgeführt zu werden. Dabei können auch solche Verläufe erzeugt werden, bei denen sich die magnetische Flußdichte z. B. quadratisch als Funktion des Ortes ändert wie in der deutschen Patentanmeldung P 34 00 861.6 beschrieben. In diesem Fall wären nur für 1 = 2 die Faktoren $c_{lm}$ von Null verschieden. Wenn die Berechnung auch für verschiedene zeitlich-räumliche Verläufe ergeben sollte, daß der Strom durch eine der Spulenanordnungen näherungsweise gleich Null ist, kann diese Spulenanordnung entfallen.

Es ist nicht unbedingt erforderlich, daß der räumliche Verlauf der Magnetflußdichte des von einer Spulenanordnung erzeugten Magnetfeldes zumindestens annähernd dem räumlichen Verlauf nur einer Kugelfunktion entspricht. Die Erfindung arbeitet vielmehr auch dann, wenn der Verlauf der Magnetfelder einer linearen Kombination von Kugelfunktionen entspricht. In diesem Fall würde sich die Zahl der erforderlichen Spulen aber nicht ändern. Wichtig ist allerdings dabei, daß das Magnetfeld einer Spule sich von dem jeder anderen Spule deutlich hinsichtlich der Art der Änderung (z. B. linear, quadratisch, kubisch) und/oder der Richtung, in der diese Änderung verläuft, unterscheidet. Anderenfalls könnten schon kleine Fehler bei der Ermittlung der Matrix A die für die verschiedenen Spulenanordnungen berechneten Stromverläufe wesentlich verfälschen.

Aus dem geschilderten Berechnungsverfahren ergibt sich, daß die Ströme durch sämtliche Spulenanordnungen die errechneten zeitlichen Verläufe haben müssen — also nicht nur die zusätzlichen Spulen $G_{2,2}$ ... $G_{3,-3}$. Das bedeutet also beispielsweise, daß die Spule $G_y$, die in y-Richtung einen konstanten Gradienten des Magnetfeldes erzeugt, in der Regel auch zu einem Zeitpunkt von einem Strom durchflossen werden kann, in dem lediglich ein konstanter Gradient in x-Richtung erwünscht ist. Dies ist darauf zurückzuführen, daß die beim Einschalten des Stromes durch die Spulenanordnung $G_x$ auftretenden Wirbelströme auch Magnetfelder erzeugen, die sich linear in y-Richtung ändern. Die Berechnung kann weiterhin ergeben, daß zusätzlich noch ein in z-Richtung verlaufendes, räumlich konstantes jedoch zeitlich veränderliches Magnetfeld erzeugt werden muß. Falls eine zusätzliche Spule für diese Zwecke vorhanden ist (Alternative b)), bereitet die Erzeugung eines derartigen Magnetfeldes keine Schwierigkeiten. Ist jedoch keine solche Spule vorhanden, dann ist — falls die durch ihr Fehlen hervorgerufenen Fehler nicht mehr tolerierbar sind — Abhilfe auf folgende Weise möglich :

Die Frequenz, mit der durch die Hochfrequenzspule die Kernspins angeregt werden, wird proportional zu dem berechneten Stromverlauf geändert. Auf diese Weise werden die Spins immer nur in derjenigen Schicht angeregt, die sich ergeben würde, wenn die Frequenz konstant bliebe und wenn das homogene Magnetfeld nicht schwanken würde. Weiterhin führt die Abweichungder homogenen Komponente des magnetischen Feldes von ihrem statischen Wert zu einer Phasendrehung aller Spins der angeregten Schicht. Die Phasendrehung ergibt sich dabei als zeitliches Integral dieser Abweichung. Da diese Phasenverschiebung jedoch für alle Spins gleich ist, kann sie bei der Verarbeitung des von den Kernspins in der Spule 5 induzierten Signales so berücksichtigt werden, daß sie die Meßergebnisse nicht verfälscht.

## Patentansprüche

1. Kernspintomograph mit einer Anordnung zur Erzeugung eines homogenen statischen Magnetfeldes, mit drei Spulenanordnungen, die von zeitlich veränderlichen Strömen durchflossen werden und zur Erzeugung von in Richtung des statischen Magnetfeldes verlaufenden Zusatzmagnetfeldern dienen, die sich in drei zueinander senkrechten Richtungen linear ändern, und mit einer Hochfrequenzspule zur Erzeugung eines hochfrequenten, zur Richtung des Hauptfeldes senkrechten Magnetfeldes, wobei die Magnetflußdichte des homogenen statischen Magnetfeldes durch Überlagerung eines weiteren Magnetfeldes in definierter Weise räumlich und zeitlich geändert wird, dadurch gekennzeichnet, daß wenigstens eine weitere Spulenanordnung ($G_{2,2}$ ... $G_{3,-3}$) vorhanden ist zur Erzeugung eines ebenfalls in Richtung des Hauptfeldes verlaufenden Magnetfeldes, das sich räumlich nichtlinear ändert, und daß der zeitliche Verlauf der Ströme durch die Spulenanordnungen so bemessen ist, daß sich durch Überlagerung der Magnetfelder sämtlicher Spulenanordnungen die definierte zeitlich-räumliche Änderung der Magnetflußdichte ergibt.

2. Kernspintomograph nach Anspruch 1, dadurch gekennzeichnet, daß bis zu fünf zusätzliche Spulenanordnungen vorgesehen sind, die Magnetfelder erzeugen, deren räumlicher Verlauf dem räumlichen Verlauf je einer der Kugelfunktionen zweiter Ordnung entspricht.

3. Kernspintomograph nach Anspruch 2, dadurch gekennzeichnet, daß bis zu sieben weitere Spulenanordnungen vorgesehen sind, die ein Magnetfeld erzeugen, dessen räumlicher Verlauf dem räumlichen Verlauf je einer der Kugelfunktionen dritter Ordnung entspricht.


## Claims

1. A nuclear magnetic resonance tomograph, comprising a system for generating a homogeneous, steady magnetic field, three coil systems wherethrough currents flow which vary in time and which serve to generate additional magnetic fields which extend in the direction of the steady magnetic field and which vary linearly in three mutually perpendicular directions, and also comprising an RF coil for generating an RF magnetic field perpendicularly to the direction of the main field, the magnetic flux density of the homogeneous steady magnetic field being varied in space and time in a defined manner by superposition of a further magnetic field, characterized in that there is provided at least one further coil system ($G_{2,2}$ ... $G_{3,-3}$) for generating a magnetic field which also extends in the direction of the main field and which varies non-linearly in space, the variation in time of the currents through the coil systems being proportioned so that the defined variation in time and space of the magnetic flux density is obtained by superposition of the magnetic fields of all coil systems.

2. A nuclear magnetic resonance tomograph as claimed in Claim 1, characterized in that there are provided up to five additional coil systems which generate magnetic fields whose variation in space corresponds to the variation in space of each time one of the second-order spherical functions.

3. A nuclear magnetic resonance tomograph as claimed in Claim 2, characterized in that there are provided up to seven further coil systems which generate a magnetic field whose variation in space corresponds to the variation in space of each time one of the third-order spherical functions.


## Revendications

1. Appareil de tomographie à résonance magnétique nucléaire comportant un système pour produire un champ magnétique statique homogène, comprenant trois montages de bobines, qui sont traversés par des courants variables dans le temps et sont destinés à produire des champs magnétiques supplémentaires s'étendant dans le sens du champ magnétique statique, qui varient linéairement dans trois sens mutuellement perpendiculaires, et une bobine haute fréquence pour produire un champ magnétique à haute fréquence perpendiculaire au sens du champ principal, la densité du flux magnétique du champ magnétique statique homogène étant amenée à varier dans l'espace et dans le temps d'une manière définie par superposition d'un autre champ magnétique, caractérisé en ce qu'au moins un autre montage de bobines ($G_{2,2}$, ..., $G_{3,-3}$) est présent pour produire un champ magnétique s'étendant également dans le sens du champ principal, qui accuse une variation spatiale non linéaire, et que l'allure temporelle conférée aux courants passant dans les montages de bobines est propre à assurer l'obtention de la variation spatio-temporelle définie de la densité de flux magnétique par superposition des champs magnétiques de tous les montages de bobines.

2. Appareil de tomographie à résonance magnétique nucléaire suivant la revendication 1, caractérisé en ce qu'il comprend jusqu'à cinq montages de bobines supplémentaires qui produisent des champs magnétiques dont les allures spatiales correspondent respectivement aux diverses allures spatiales des fonctions sphériques de degré deux.

3. Appareil de tomographie à résonance magnétique nucléaire suivant la revendication 2, caractérisé en ce qu'il comprend jusqu'à sept autres montages de bobines produisant un champ magnétique dont l'allure spatiale correspond chaque fois à l'allure spatiale d'une des fonctions sphériques de degré trois.

FIG.1

FIG.2